# EUROPEAN PATENT APPLICATION

(11) **EP 2 683 033 A1**
(43) Date of publication of application: **08.01.2014**
(21) Application number: 12752739.8
(22) Date of filing: 02.03.2012
(51) Int. Cl.: H01R 4/02, B23K 1/19, B23K 35/26, B60S 1/58, C03C 27/04, C22C 13/00, H01Q 1/32

(54) **TERMINAL STRUCTURE FOR GLASS PLATE WITH CONDUCTIVE SECTION AND GLASS PLATE ARTICLE UTILIZING SAME**

(30) Priority: 02.03.2011 JP 2011045332
(71) Applicant: Central Glass Company, Limited, Yamaguchi 755-0001 (JP)
(72) Inventor: OGAWA, Takayuki, Chiyoda-ku, Tokyo 101-0054 (JP); NISHI, Mizuki, Matsusaka-shi, Mie 515-0001 (JP); FURUHASHI, Kazunori, Matsusaka-shi, Mie 515-0001 (JP)
(74) Representative: Manitz, Finsterwald & Partner GbR
(86) International application number: PCT/JP2012/055455
(87) International publication number: WO 2012/118202

(57) **Abstract**

Disclosed is a glass plate article having a feed terminal structure to be connected with a feeding portion of a glass plate with a conductive portion, the glass plate article being characterized by that the feed terminal structure has at least one terminal seat subjected to a surface connection with the feeding portion through a lead-free solder alloy, that the terminal seat has a laminar form prepared by removing corner portions (soldering avoidance regions), each defined by a line connecting two points that are away from each of two vertices of one side of a square or rectangle by 1.6 mm or greater and are on two sides extending from each vertex, from the square or rectangle, that a connection area per each surface connection is from 8 mm² to 98 mm², and that the terminal seat is soldered to the feeding portion by using the lead-free solder alloy, the lead-free solder alloy is a Sn-Ag-Cu-series, lead-free solder alloy that has a dispersion/precipitation strengthened structure containing 1.5 to 4 mass % of Ag and 0.5 to 2 mass % of Cu and has a Young's modulus of 40 GPa or higher at room temperature.

## Description

### TECHNICAL FIELD

The present invention relates to a feed terminal structure for connecting a feeding terminal to a feeding portion to a glass plate with a conductive portion, and a glass plate article utilizing this. In particular, it relates to a connection utilizing a lead-free solder alloy between a metal terminal and a glass surface of the feeding portion.

### BACKGROUND OF THE INVENTION

Some of automotive or architectural glass plate articles may be formed with conductive wires for electrical heating as a defogger for securing visibility. Furthermore, a glass antenna may be used on an automotive rear window or side window. In conductive wires for electrical heating and a glass antenna, a pattern of conductive wires is formed by baking a conductive paste in the form of a thin film onto the surface of a glass plate. Thus, a glass plate with a conductive portion formed of a pattern of conductive wires prepared by baking a conductive thin film onto the surface of a glass plate is referred to in the following as a glass plate with a conductive portion.

These conductive wires are provided with a metal terminal for feeding (a feeding terminal). Conventionally, the feeding terminal and a glass plate have been connected with each other with a lead-containing solder by using a single terminal seat or, as shown in, for example, Patent Publication 2, two terminal seats (seats) (cited in Fig. 9) (Patent Publications 1-3). However, in general, lead is an environmental pollution substance with a high toxicity. Therefore, there is a concern about effects on health and environment, and particularly adverse effects on ecosystem and its pollution are seen as being problematic. In particular, in case that a glass plate article utilizing a lead-containing solder has been dumped, there is a risk that lead leaches into the environment when acid rain or the like is attached to the solder.

From this point, in the household appliance industry, the production of lead-free solders for electronic substrates is rapidly expanding. However, as compared with solders for electronic substrates, a solder for connecting a glass plate with a metal terminal has a higher requirement of adhesion strength. Furthermore, due to the difference of thermal expansion coefficient between a metal terminal and a glass plate, etc., in case that an abrupt environmental temperature change occurs or in case that a repeated temperature change is large, it tends to cause a problem that stress concentrates on a soldered portion, where the glass plate and the metal terminal are connected with each other, to cause a lowering of the connection strength or cracks on the surface of the glass plates, etc.

Nowadays, a Sn-Ag-Cu-series, lead-free solder, such as Sn-3Ag-0.5Cu (a Sn alloy containing 3 mass % of Ag and 0.5 mass % of Cu), which has become the mainstream of solders for electronic substrates, is high in terms of connection strength too in electronic substrates and is one of highly reliable solder alloys. This alloy is, however, high in Young's modulus and a metal high in stiffness. For example, an alloy having a composition of 3.5 mass % Ag, 1.0 mass % Cu and the balance being Sn is reported to have a Young's modulus of 41.6 GPa at ordinary temperature (Comparative Example No. 3 described in Patent Publication 4). Thus, Sn-Ag-Cu-series, lead-free solders do not have a softness as that of Sn-Pb alloy-series solders, and it is difficult to relax a stress generated in a soldered article. Therefore, it cannot be used in the original condition for the use of a connection between a glass plate with a high stiffness and a metal terminal.

As to a technique for connecting a terminal structure, which has a structure by connecting two terminal seats with a stem portion, by using a lead-free solder, Patent Publication 5 discloses a structure in which a thermal stress accompanying soldering is relaxed to prevent the occurrence of cracks on the surface of the glass plate after a thermal shock test, by connecting a conductive film formed by baking a silver paste, with a lead-free solder alloy containing Ag by 1.5 mass % to 5 mass % and by defining the total area of a connecting surface of the terminal and the volume of the solder.

Furthermore, Patent Publication 6 discloses a vehicular glass panel prepared by using a lead-free solder containing a stress relaxing component selected from Bi, In and Sb and Sn by an amount of less than 90 %. This lead-free solder takes into account the lowering of stress generated at the initial stage accompanying the soldering. However, due to being high in Young's modulus, if it is used in the cold such as a cold district, there is a risk that the solver shrinks to cause cracks in the glass, thereby lowering strength of the glass during using the vehicle.

### PRIOR ART PUBLICATIONS

### PATENT PUBLICATIONS

Patent Publication 1: Japanese Utility Model Examined Publication No. Showa 61-37182
Patent Publication 2: Japanese Utility Model Application Publication No. Showa 64-27961
Patent Publication 3: Japanese Utility Model Application Publication No. Heisei 6-58557
Patent Publication 4: Japanese Patent Application Publication No. 2001-71173
Patent Publication 5: Japanese Patent No. 3957302
Patent Publication 6: Japanese Patent Application Publication No. 2006-523917

### SUMMARY OF THE INVENTION

Ag-Sn alloy-series, lead-free solder as an alternative to Pb-Sn solder, which has a low melting point and is superior in adhesion, has a high melting point of 217 to 219 °C. Therefore, in the case of soldering to a glass plate, it is necessary to prevent the occurrence of a stress by a partial thermal expansion of the glass plate. Thus, as shown in Patent Publication 5, there have been proposed in the past some means for preventing the occurrence of cracks in the soldering step.

In a terminal structure prepared by connecting a metal terminal with a conductive portion of a glass plate with the conductive portion, formed with the conductive portion, by a solder, there has been a tendency to use a lead-free solder as the solder. In lead-free solders with high contents of Sn, however, the connection with the conductive portion formed by a Ag-containing paste is made insufficient by a Ag-free solder or a solder with a low content of Ag. As a result, there is a risk that the terminal comes off to lose electrical conduction performance.

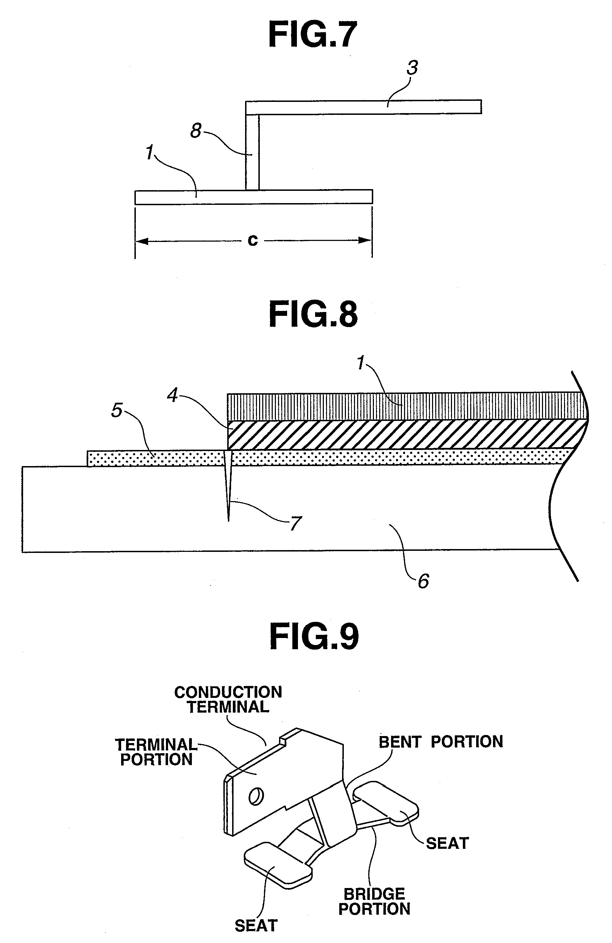

On the other hand, the use of a Sn alloy-series, lead-free solder with a high content of Ag improves the strength of a connection with the conductive portion, but Young's modulus of the solder layer becomes high. Thus, even if the occurrence of stress upon soldering can be prevented, it is difficult to relax stress generated in the glass plate of the soldered portion by the environmental temperature change during the use, particularly due to the difference of thermal expansion coefficient between the terminal structure and the glass plate. As shown in Fig. 8, there is a risk to generate cracks 7 in the direction of thickness of the glass plate in the vicinity of a corner of the terminal seat when soldering the conductive portion 5 of the glass plate 6 and the terminal seat 1 by the solder layer 4. Thermal expansion coefficient of copper or brass used for the terminal structure is around 16 × 10⁻⁶ to 19 ×10⁻⁶/°C, and thermal expansion coefficient of glass is around 8.5 × 10⁻⁶ to 9 ×10⁻⁶/°C.

Thus, in the case of using a Sn-Ag-Cu-series, lead-free solder with a high Young's modulus, the metal terminal to be connected with the conductive portion of the glass plate with the conductive portion, formed with the conductive portion, has a problem that the occurrence of cracks of the glass plate by the environmental temperature change during the use cannot be prevented unless both conditions of the solder component and the terminal structure are satisfied. Such characteristic can be judged by measuring the connection strength after a cooling/heating cycle resistance test.

According to the present invention, there is provided a glass plate article having a feed terminal structure (in the following, it may be expressed as simply "the terminal structure") to be connected with a feeding portion of a glass plate with a conductive portion, the glass plate article (a first article) being characterized by that the feed terminal structure has at least one terminal seat subjected to a surface connection with the feeding portion through a lead-free solder alloy,
that the terminal seat has a laminar form prepared by removing corner portions (soldering avoidance regions), each defined by a line connecting two points that are away from each of two vertices of one side of a square or rectangle by 1.6 mm or greater and are on two sides extending from each vertex, from the square or rectangle,
that a connection area per each surface connection is from 8 mm² to 98 mm², and
that the terminal seat is soldered to the feeding portion by using the lead-free solder alloy, the lead-free solder alloy is a Sn-Ag-Cu-series, lead-free solder alloy that has a dispersion/precipitation strengthened structure containing 1.5 to 4 mass % of Ag and 0.5 to 2 mass % of Cu and has a Young's modulus of 40 GPa or higher at room temperature.

The first article may be a glass plate article (a second article) characterized by that thermal expansion coefficient of a material of the feed terminal structure is 16 × 10⁻⁶ to 19 ×10⁻⁶/°C.

The first or second article may be a glass plate article (a third article) characterized by that the conductive portion is a conductive wire of a vehicular glass antenna or defogger.

Any one of the first to third articles may be a glass plate article (a fourth article) characterized by that the terminal seat is formed of a pair of terminal seats, and the feed terminal structure comprises a stem portion formed to bridge the pair of the terminal seats.

Any one of the first to fourth articles may be a glass plate article (a fifth article) characterized by that Cu content of the lead-free alloy is 0.55 to 2 mass %.

Any one of the first to fifth articles may be a glass plate article (a sixth article) characterized by that material of the terminal seat is copper or brass.

Any one of the first to sixth articles may be a glass plate article (a seventh article) characterized by that thickness of the terminal seat is 0.2 to 1.0 mm.

Any one of the first to seventh articles may be a glass plate article (an eighth article) characterized by that thickness of the solder layer between the terminal seat and the conductive portion is 0.1 to 2.0 mm.

Furthermore, according to the present invention, there is provided a process for connecting a terminal structure with a feeding portion of a glass plate with a conductive portion, which is characterized by that the feed terminal structure according to any one of the first to eighth articles is soldered to a feeding portion of a glass plate with a conductive portion by using the Sn-Ag-Cu-series, lead-free solder alloy according to any one of the first to eighth articles.

### ADVANTAGEOUS EFFECT OF THE INVENTION

The present invention provides a terminal structure that has a structure for relaxing stress of a solder connection portion, even if a connection portion with a high connection strength is formed by using particularly a Sn-Ag-Cu-series, lead-free solder with a high Young's modulus, that causes no cracks in a glass plate in the vicinity of the solder connection portion due to the environmental temperature change during use, and that is preferable for connecting a metal terminal with a glass plate article.

### BRIEF DESCRIPTION OF THE DRAWINGS

Fig. 1 is a side view of a terminal configuration example of a terminal structure of the present invention;
Fig. 2 is a top view of the terminal configuration example of the terminal structure of the present invention;
Fig. 3 is a top view showing one example (a polygonal corner portion cutting off) of a terminal seat configuration of an example of the present invention;
Fig. 4 is a top view showing one example (a corner portion cutting off) of a terminal seat configuration of an example of the present invention;
Fig. 5 is a top view showing one example (a R side cutting off) of a terminal seat configuration of an example of the present invention;
Fig. 6 is a top view showing one example (a rectangle) of a terminal seat configuration, which is different from the present invention;
Fig. 7 is a side view of a terminal configuration example of the present invention;
Fig. 8 is a view showing a condition in which cracks have occurred in the vicinity of a soldered portion in one example (a rectangle) of a terminal seat configuration, which is different from the present invention; and
Fig. 9 is a perspective view showing a metal terminal example having two terminal seats.

### DETAILED DESCRIPTION

The present invention is characterized by a configuration of a solder connection surface of a terminal seat in a terminal structure having at least one terminal seat. Furthermore, it relates to a connection with a high connection strength between a terminal and a conductive portion of a glass plate surface by using a Sn-based solder alloy containing Ag and Cu and having a high Young's modulus.

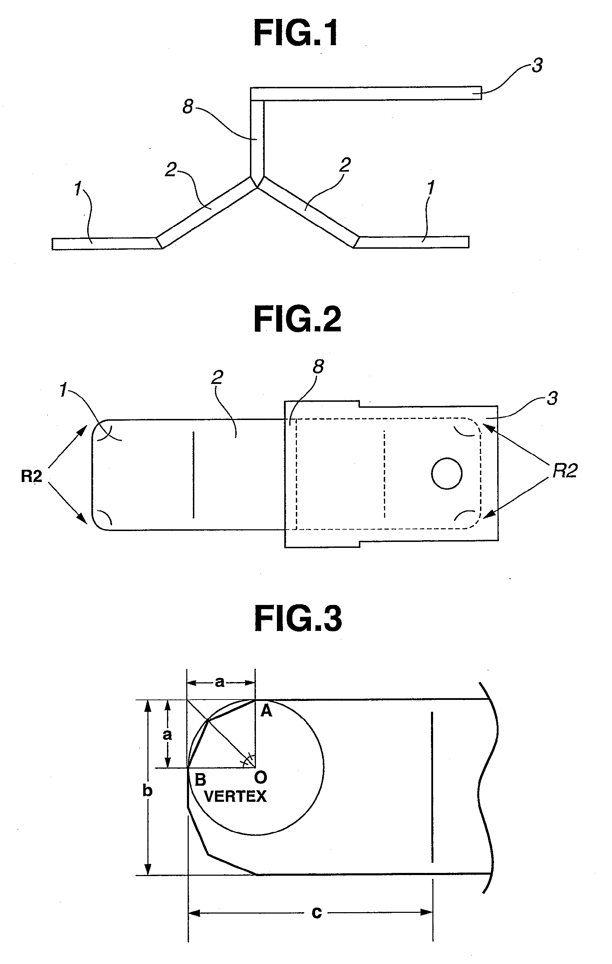

A preferable example of a terminal structure of the present invention is shown in Fig. 1 (a side view) and Fig. 2 (a top view). For the terminal, generally from the viewpoints of conductivity and easiness of machining, a conductive substance, such as copper or brass, having a thermal expansion coefficient of around 16 × 10⁻⁶ to 19 ×10⁻⁶/°C is favorable, and it is desirable to be one prepared by punching a material easy in machining.

The terminal structure of Fig. 1 and Fig. 2 is formed of a pair of terminal seats 1, stem portions 2 for connecting these, a supporting portion 8 for connecting these, and a connecting portion 3 connected to this. For the terminal structure, it is necessary to have a section for connecting an electrical cable. When connecting an electrical cable to this section, the terminal structure and a connection region (a region formed of the terminal seat, the solder, and the glass) of the structure tend to have a load. As shown in Fig. 1 and Fig. 2, a structure formed of a pair of terminal seats 1 and stem portions 2 for connecting these is a structure that is effective for relaxing the load, when connecting an electrical cable to connecting portion 3. It is one that has less load on the connection region of the structure and that is effective for maintaining strength of the connection region of the structure.

In the present invention, the terminal structure is not limited to the above-mentioned one, but it suffices to have at least one terminal seat. For example, it may be a terminal structure having a single terminal seat (see Fig. 7).

In the following, a terminal seat example of a preferable terminal structure is described in detail.

As shown in Fig. 3, the terminal seat of the terminal structure of the present invention has a soldering avoidance region. In other words, each terminal seat of the present invention has a shape (a shape prepared by removing the soldering avoidance region from each corner portion) prepared by chamfering as mentioned hereinafter, from a square or rectangle, two corner portions defining one side thereof.

The connection area of the terminal seat is from 8 mm² to 98 mm². If it is smaller than 8 mm², the area of the terminal seat becomes too small to maintain the connection strength. Being larger than 98 mm² is not preferable, since its external appearance becomes bad, and the material cost becomes high, in the case of using it for an automotive glass plate. Preferably, it is 11 mm² to 62 mm². More preferably, it is 14 mm² to 34 mm². Specifically, it suffices that width b and length c of the terminal seat of the terminal structure of the present invention are around 3.2 to 10 mm (the area of the square or rectangular shape prior to the cutting off is 10 to 100 mm²). Width b refers to the distance in the direction making a right angle with the direction of a straight line connecting a pair of terminal seats. Length c refers to the distance in the direction of the straight line. If width b and length c of the terminal seat are smaller than 3.2 mm, the area of the terminal seat portion becomes too small to maintain the connection strength. Furthermore, even if cutting the corner portions off, the area of the portions cut off becomes small. This lowers the effect of relaxing stress, resulting in the possibility of the occurrence of cracks. Being larger than 10 mm is not preferable, since its external appearance becomes bad, and the material cost becomes high, in the case of using it for an automotive glass plate. Therefore, width b and length c of the terminal seat are in a range of 3.2 to 10 mm (the area of the square or rectangular shape prior to the cutting off is 10 to 100 mm²), preferably 3.6 to 8 mm (the area of the square or rectangular shape prior to the cutting off is 13 to 64 mm²), more preferably 4 to 6 mm (the area of the square or rectangular shape prior to the cutting off is 16 to 36 mm²). It is preferable that the connection area of the terminal seat, that is, the soldering region, is made to be substantially the same as the area of the terminal seat.

The terminal seat has a shape prepared by cutting off the soldering avoidance regions from both corner portions of a square or rectangular, laminar form on the opposite side of the stem portion. As shown in Fig. 3, the soldering avoidance region refers to a region that is defined by a line connecting positions A and B that are on both sides and have a distance "a" from a vertex of the square or rectangle of 1.6 mm or longer, and that is cut off from both corner portions of a square or rectangular, laminar form on the opposite side of the stem portion. The connection area per each terminal seat after cutting off the soldering avoidance regions is from 8 mm² to 98 mm².

The line connecting the positions A and B may be a straight line(s) or a curve such as arc and is not particularly defined. The distance "a" from the vertex of the corner portion is preferably 1.6 mm or greater. If it is made to be smaller than 1.6 mm, the effect of relaxing stress lowers to have a possibility of the occurrence of cracks. More preferably, it is 1.8 to b/2 mm and 1.8 to c/2 mm. More preferably, it is 2.0 to b/2 mm and 2.0 to c/2 mm.

It is desirable that the material of the terminal seat is copper or brass from the viewpoint of conductivity and easiness of machining, similar to the terminal. It is desirable that the thickness of the terminal seat is 0.2 to 1.0 mm. More desirably, it is 0.4 to 0.8 mm.

In general, it is dangerous in handling or the like, if the present terminals have corners. Thus, as shown in the drawings of Patent Publications 1 and 2, it is a customary means to treat the corner portion with C1 chamfering (to remove the corner portion along a straight line connecting two points that are away from the corner of the terminal seat by 1 mm and are on two sides extending from the corner) or R1 chamfering (to remove the corner portion along an arc that is convex towards the corner side and passes through two points that are away from the corner of the terminal seat by 1 mm and are on two sides extending from the corner). Such means did not sufficiently relax stress generated at the corner portion and resulted in the occurrence of cracks in the case of using a lead-free solder with a high Young's modulus as mentioned above. Therefore, there is provided a soldering avoidance structure for relaxing stress particularly at this corner portion, and this corner portion is removed by making the above-mentioned one side "a" have 1.6 mm or greater. With this, stress does not concentrate on the leading end of the terminal seat 1, even if using a lead-free solder with a high Young's modulus. Therefore, cracks are not generated in the vicinity of the soldered portion of a glass plate with a conductive portion.

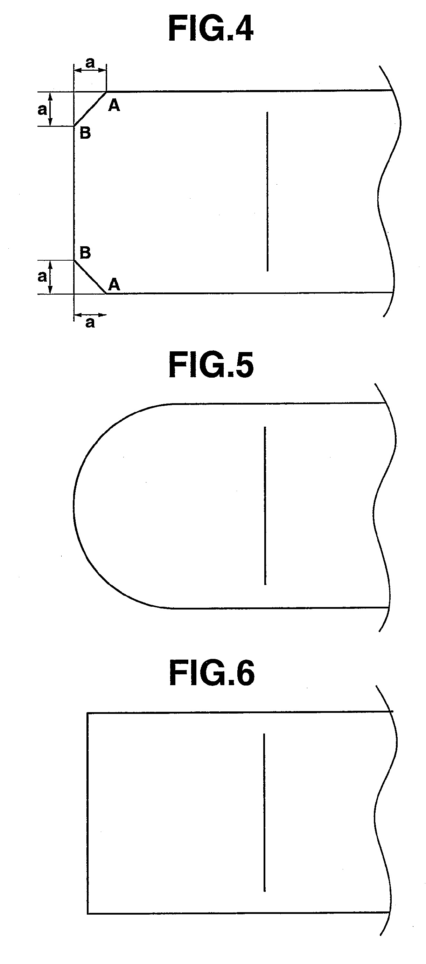

For comparison, an example of a terminal structure different from the present invention is shown in Fig. 6.

As to composition of the lead-free solder alloy, it is possible to use a lead-free solder alloy with a high Young's modulus, since the terminal structure of the present invention is capable of relaxing stress. In particular, a Sn-Ag-Cu-series, lead-free solder alloy is desirable, which contains 1.5-4 mass %, more preferably 2-3.5 mass %, of Ag and 0.5-2 mass %, more preferably 0.5-1 mass %, of Cu and has a Young's modulus of from 40 GPa to 55 GPa at room temperature (25 °C) in a measurement method conforming to JIS Z 2280. This alloy has a dispersion/precipitation strengthened structure, in which intermetallic compounds of Ag₃Sn and Cu₆Sn₅ crystallize, and Ag₃Sn/Sn eutectic structures precipitate as fine crystals in a manner to surround Sn primary crystals, and is referred to as a dispersion/precipitation strengthened structure. This Sn-Ag-Cu-series solder alloy has a melting point higher than that of Sn-Pb alloy, and has a higher elastic modulus and a higher thermal conductivity, too.

The reason why such composition is desirable is as follows.

If Ag is less than 1.5 mass %, strength of a connection with a conductive portion formed from a Ag-containing paste lowers. If it exceeds 4 mass %, fine cracks develop over the solder surface to lower mechanical characteristics. This Sn-Ag-Cu-series solder alloy has a higher Young's modulus in proportion to the increase of the Ag content.

If Cu is less than 0.5 mass %, the network of the Ag₃Sn intermetallic compound precipitated in the alloy structure becomes thin, and the connection strength lowers as time goes by. Furthermore, the formation of the Cu₆Sn₅ alloy layer at the interface with the terminal also becomes insufficient, and thereby it is not possible to sufficiently secure a connection with the terminal. Therefore, Cu is 0.5 mass % or greater, preferably 0.55 mass % or higher, more preferably 0.6 mass % or higher. If it exceeds 2 mass %, the solver becomes hard and brittle. Therefore, the connection strength lowers. Desirably, it is 1 mass % or lower.

As the Sn-Ag-Cu-series, lead-free solder alloy, specifically, it is possible to cite, for example, Sn-3.5Ag-0.5Cu, Sn-3.5Ag-0.6Cu, Sn-3.5Ag-0.7Cu, Sn-3.5Ag-0.5Cu-0.07Ni-0.01Ge, Sn-3.5Ag-0.5Bi-8.0In-0.55Cu, Sn-3.2Ag-2.7Bi-2.7In-0.6Cu, Sn-2.5Ag-1Bi-0.5Cu, Sn-3.5Ag-4.8Bi, Sn-2Ag-7.5Bi-0.5Cu, etc. The numeral added on the left of the element represents mass % of the element. The element with no addition of numeral means that the balance is denoted by the element.

The thickness of the solder layer between the terminal seat 1 and the conductive portion after the soldering is desirable to be 0.1-2 mm. If the thickness of the solder layer is less than 0.1 mm, the amount of the solder is insufficient, resulting in lowering of the connection strength. On the other hand, if the thickness of the solder layer exceeds 2 mm, the terminal structure cannot continue to relax stress caused by the difference of thermal expansion between that and the glass plate, in the case of using a lead-free solder with a high Young's modulus. With this, cracks may occur in the vicinity of the soldered portion. It is desirable to conduct soldering of the terminal by a method in which a solder is placed on the bottom surface of the terminal seat, and then the solder is heated at the melting point or higher by a hot-air heater or the like and welded to the conductive portion, followed by cooling. It is optional to use, for example, a resistance heating method in which a voltage is applied, while the terminal having a solder previously placed thereon is held and pressed between electrodes, and thereby the welding is conducted by using heat generation due to resistance of the terminal portion, etc. The method is not limited.

The conductive portion is formed by subjecting a paste prepared by adding an organic medium to conductor main components that are silver powder, a low-melting-point glass frit, a metal oxide powder as a resistance adjusting agent, etc., to a pattern printing and then baking, to make a pattern of the conductive film. In the present invention, the conductive portion is not limited in terms of its material and forming method.

The present invention is capable of improving the connection strength between a glass plate with a conductive portion and a terminal by a metal terminal structure and a lead-free solder composition. In particular, it is preferably used for conductive portions of antennas, defoggers, etc.

### EXAMPLES

In the following, the present invention is exemplarily explained, based on examples.

A terminal of a structure shown in Figs. 1 and 2 was manufactured. A punching was conducted by using a material of C2801P (a brass plate) defined in JIS H 3100. The thickness of the plate is 0.4 mm. The length of one stem portion 2 bridging one terminal seat 1 and the supporting portion 8 is 4.5 mm.

In Example 1, as shown in Figs. 2 and 3 and Table 1, the terminal seat 1 was prepared (the connection area per each terminal seat: 23.3 mm²) by setting the width b and the length c of the terminal seat 1 each at 5 mm and cutting off each corner portion at R2 (an arc that is convex towards the corner side and passes through two points A and B of "a" = 2 mm).

In Example 2, as shown in Fig. 3 and Table 1, the terminal seat 1 was prepared (the connection area per each terminal seat: 28.5 mm²) by setting the width b and the length c of the terminal seat 1 respectively at 5 mm and 6 mm and cutting off each corner portion along a straight line connecting the point A (a = 1.6 mm) and a point of intersection of a straight line dividing the central angle ○ (90 °) of a quadrant having a radius of 1.6 mm into two equal parts, with the quadrant, and a straight line connecting the point B (a = 1.6 mm) and the point of intersection.

In Example 3, as shown in Fig. 4 and Table 1, the terminal seat 1 was prepared (the connection area per each terminal seat: 25.7 mm²) by setting the width b and the length c of the terminal seat 1 respectively at 6 mm and 4.5 mm and cutting off each corner portion at C1.6 (a straight line passing through two points A and B of "a" = 1.6 mm).

In Example 4, as shown in Fig. 5 and Table 1, the terminal seat 1 was prepared (the connection area per each terminal seat: 44.1 mm²) by setting the width b and the length c of the terminal seat 1 respectively at 6 mm and 8 mm and cutting off each corner portion at R3 (an arc that is convex towards the corner side and passes through two points of "a" = 3 mm).

In Examples 5-9, as shown in Table 1, the terminal seat 1 was prepared (see Fig. 2) by setting the width b at 4 mm and the length c at 5 mm and cutting off each corner portion at R1.6 (an arc that is convex towards the corner side and passes through two points of "a" = 1.6 mm).

In Example 10, as shown in Fig. 7 and Table 1, there was prepared a terminal formed of the terminal seat 1, the supporting portion 8 and a part 3 extending in parallel with the terminal seat 1 and with no stem portion. The terminal seat 1 was prepared by setting the width b at 4 mm and the length c at 9 mm and cutting off each corner portion at R2.

In Comparative Example 1, as shown in Figs. 1 and 6 and Table 2, there was prepared a terminal by setting the length c of the stem portion 2 at 4.5 mm and setting the width b and the length c respectively at 6 m and 5 mm and having a terminal seat (the connection area per each terminal seat: 30.0 mm²) that was rectangular and had a corner potion of an angle of 90 degrees.

In Comparative Example 2, as shown in Table 2, the terminal seat 1 was prepared (see Fig. 2) by setting the width b and the length c of the terminal seat respectively at 4 mm and 5 mm and cutting off each corner portion at R1.5 (an arc that is convex towards the corner side and passes through two points of "a" = 1.5 mm).

In Comparative Example 3, as shown in Table 2, the terminal seat 1 was prepared (see Fig. 4) by setting the width b and the length c of the terminal seat 1 each at 4 mm and cutting off each corner portion at C1 (a straight line passing through two points of "a" = 1 mm).

In Comparative Examples 4-6, as shown in Table 2, the terminal seat 1 was prepared (see Fig. 2) by setting the width b and the length c of the terminal seat 1 respectively at 5 mm and 6 mm and cutting off each corner portion at R2.

In Comparative Example 7, as shown in Table 2, the terminal seat 1 was prepared (see Fig. 2) by setting the width b and the length c of the terminal seat 1 each at 3 mm and cutting off each corner portion at R1.5 (an arc that is convex towards the corner side and passes through two points of "a" = 1.5 mm).

Similar to Example 10, in Comparative Example 8, as shown in Fig. 7 and Table 2, there was prepared a terminal formed of the terminal seat 1, the supporting portion 8 and a part 3 extending in parallel with the terminal seat 1 and with no stem portion. The terminal seat 1 was prepared by setting the width b at 4 mm and the length c at 9 mm and cutting off each corner portion at R2 (an arc that is convex towards the corner side and passes through two points of "a" = 2 mm).

A conducting portion was formed by making a silver print (size: 12 × 70 mm) by printing a silver paste formed of fine silver particles, a low-melting-point glass frit containing a Bi-series borosilicate glass as a main component, and a solvent containing terpineol as a main component on a soda-lime glass plate using a screen of a mesh # 200. After drying this glass plate, a heating treatment was conducted for 3 minutes in an atmosphere of 700 °C to make a tempered glass.

The terminal seat was subjected to a surface connection to the conductive portion by placing a solder alloy having a composition shown in Table 1 on the terminal seat to have a thickness of 2 mm from the surface of the terminal seat, followed by setting on the conductive portion on the glass plate, heating for 20 to 25 seconds by a hot air of 350 to 400 °C to melt the solder, and then slow cooling to achieve soldering.

The qualities of the solder composition and the terminal structure were judged by adding a thermal expansion difference to the glass plate and the terminal by conducting a cooling/heating cycle resistance test with reference to JIS C2807. That is, connection strength was measured after repeating 100 cycles, while defining 1 cycle as "20°C (3 minutes) → -30°C (30 minutes) → 20°C (3 minutes) → 85°C (30 minutes) → 20°C (3 minutes)". In JIS C2807, the lower side temperature is -25°C. Then, the connected portion of the terminal was pulled with reference to JIS C60068 by using a push-pull gauge in the direction perpendicular to the surface of connection between the conductive portion and the terminal seat to measure the strength of connection with the conductive portion. One with no peeling off under 80 N was judged as being satisfactory (a circle mark) in connection strength. Furthermore, one with no cracks in the glass plate was judged as being satisfactory (a circle mark) in external appearance.

### (Results)

The terminal structure, the solder composition, and the test results are shown in tables.

**[Table 1]**

| Ex. | Terminal seat shape | | Solder composition (mass %) | | | | |
|---|---|---|---|---|---|---|---|
| | Dimensions | Connection area (mm²) | Sn | Ag | Cu | Connection strength | Cracks |
| | R2 cutting off | | | | | | |
| 1 | a=2mm | 23.3 | 95.2 | 3.8 | 1.0 | O | O |
| | b=5mm | | | | | | |
| | c=5mm (Fig.2) | | | | | | |
| | Polygonal cutting off | | | | | | |
| 2 | a= 1.6mm | 28.5 | 95.2 | 3.8 | 1.0 | O | O |
| | b=5mm | | | | | | |
| | c=6mm (Fig. 3) | | | | | | |
| | C1.6 cutting off | | | | | | |
| 3 | a= 1.6mm | 25.7 | 95.2 | 3.8 | 1.0 | O | O |
| | b=6mm | | | | | | |
| | c=4.5mm (Fig. 4) | | | | | | |
| | R3 cutting off | | | | | | |
| 4 | a=3mm | 44.1 | 95.2 | 3.8 | 1.0 | O | O |
| | b=6mm | | | | | | |
| | c=8mm (Fig. 5) | | | | | | |
| | R1.6 cutting off | | | | | | |
| 5 | a=1.6mm | 18.9 | 95.2 | 3.8 | 1.0 | O | O |
| | b=4mm | | | | | | |
| | c=5mm (Fig. 2) | | | | | | |
| | R1.6 cutting off | | | | | | |
| 6 | a= 1.6mm | 18.9 | 96.0 | 3.5 | 0.5 | O | O |
| | b=4mm | | | | | | |
| | c=5mm (Fig. 2) | | | | | | |
| | R1.6 cutting off | | | | | | |
| 7 | a= 1.6mm | 18.9 | 96.5 | 2.5 | 1.0 | O | O |
| | b=4mm | | | | | | |
| | c=5mm (Fig. 2) | | | | | | |
| | R1.6 cutting off | | | | | | |
| 8 | a= 1.6mm | 18.9 | 96.5 | 2.0 | 1.5 | O | O |
| | b=4mm | | | | | | |
| | c=5mm (Fig. 2) | | | | | | |
| | R1.6 cutting off | | | | | | |
| 9 | a= 1.6mm | 18.9 | 96.5 | 3.5 | 1.0 | O | O |
| | b=4mm | | | | | | |
| | c=5mm (Fig. 2) | | | | | | |
| | R2 cutting off | | | | | | |
| 10 | a=2mm | 34.3 | 95.2 | 3.8 | 1.0 | O | O |
| | b=4mm | | | | | | |
| | c=9mm (Fig. 7) | | | | | | |

**[Table 2]**

| Com. Ex. | Terminal seat shape | | Solder composition (mass %) | | | | |
|---|---|---|---|---|---|---|---|
| | Dimensions | Connection area (mm²) | Sn | Ag | Cu | Connection strength | Cracks |
| | Rectangle | | | | | | |
| 1 | b=6mm | 30.0 | 95.2 | 3.8 | 1.0 | O | × |
| | c=5mm (Fig.6) | | | | | | |
| | R1.5 cutting off | | | | | | |
| 2 | a= 1.5mm | 19.0 | 95.2 | 3.8 | 1.0 | O | × |
| | b=4mm, c=5mm | | | | | | |
| | C1 cutting off | | | | | | |
| 3 | a=1mm | 15.0 | 95.2 | 3.8 | 1.0 | O | × |
| | b=4mm, c=4mm | | | | | | |
| | R2 cutting off | | | | | | |
| 4 | a=2mm | 28.3 | 99.0 | 1.0 | 0.0 | × | O |
| | b=5mm, c=6mm | | | | | | |
| | R2 cutting off | | | | | | |
| 5 | a=2mm | 28.3 | 94.0 | 5.0 | 1.0 | × | O |
| | b=5mm, c=6mm | | | | | | |
| | R2 cutting off | | | | | | |
| 6 | a=2mm | 28.3 | 98.5 | 0.5 | 1.0 | × | O |
| | b=5mm, c=6mm | | | | | | |
| | R1.5 cutting off | | | | | | |
| 7 | a= 1.5mm | 8.0 | 95.2 | 3.8 | 1.0 | × | × |
| | b=3mm, c=3mm | | | | | | |
| | R2 cutting off | | | | | | |
| 8 | a=2mm | 34.3 | 99.0 | 1.0 | 0.0 | × | O |
| | b=4mm | | | | | | |
| | c=9mm (Fig. 7) | | | | | | |

As shown in Examples 1-10 in Table 1, ones of the terminal seat shapes and the solder compositions of the present invention were good in connection strength, and cracks were not generated.

On the other hand, although having stem portions, Comparative Examples 1-3 of the terminal seat shapes different from those of the present invention were good in connection strength, but cracks were generated. Furthermore, although having terminal structures of the present invention, Comparative Examples 4-6 and 8 having solder compositions different from those of the present invention were good in external appearance, but the connection strengths were weak. Furthermore, in Comparative Example 7 of a terminal seat shape different from that of the present invention, the connection strength was not good due to a small contact area, and cracks were generated since the soldering avoidance region was also small.

### INDUSTRIAL APPLICABILITY

The present invention provides a terminal structure that has a high connection strength, even if particularly a lead-free solder of a high Young's modulus is used, that is provided with a stress relaxing structure, and that is preferable for a connection between a metal terminal and a glass plate article. Its application is possible in a wide field of conductive wire's terminal structures, etc. of automotive glass antennas and defoggers, architectural glass plates, etc.

### EXPLANATION OF THE SYMBOLS

- 1: a terminal seat
- 2: a stem portion
- 3: a connecting portion
- 4: a solder layer
- 5: a conductive portion
- 6: a glass plate
- 7: a crack
- 8: a supporting portion

## Claims

1. A glass plate article having a feed terminal structure to be connected with a feeding portion of a glass plate with a conductive portion, the glass plate article being **characterized by** that the feed terminal structure has at least one terminal seat subjected to a surface connection with the feeding portion through a lead-free solder alloy,
that the terminal seat has a laminar form prepared by removing corner portions (soldering avoidance regions), each defined by a line connecting two points that are away from each of two vertices of one side of a square or rectangle by 1.6 mm or greater and are on two sides extending from each vertex, from the square or rectangle,
that a connection area per each surface connection is from 8 mm² to 98 mm², and
that the terminal seat is soldered to the feeding portion by using the lead-free solder alloy, the lead-free solder alloy is a Sn-Ag-Cu-series, lead-free solder alloy that has a dispersion/precipitation strengthened structure containing 1.5 to 4 mass % of Ag and 0.5 to 2 mass % of Cu and has a Young's modulus of 40 GPa or higher at room temperature.

2. The glass plate article as claimed in claim 1, **characterized by** that thermal expansion coefficient of a material of the feed terminal structure is 16 × 10⁻⁶ to 19 ×10⁻⁶/°C.

3. The glass plate article as claimed in claim 1 or 2, **characterized by** that the conductive portion is a conductive wire of a vehicular glass antenna or defogger.

4. The glass plate article as claimed in any one of claims 1 to 3, **characterized by** that the terminal seat is formed of a pair of terminal seats, and the feed terminal structure comprises a stem portion formed to bridge the pair of the terminal seats.

5. The glass plate article as claimed in any one of claims 1 to 4, **characterized by** that Cu content of the lead-free alloy is 0.55 to 2 mass %.

6. The glass plate article as claimed in any one of claims 1 to 5, **characterized by** that material of the terminal seat is copper or brass.

7. The glass plate article as claimed in any one of claims 1 to 6, **characterized by** that thickness of the terminal seat is 0.2 to 1.0 mm.

8. The glass plate article as claimed in any one of claims 1 to 7, **characterized by** that thickness of the solder layer between the terminal seat and the conductive portion is 0.1 to 2.0 mm.

9. A process for connecting a terminal structure with a feeding portion of a glass plate with a conductive portion, which is **characterized by** that the feed terminal structure according to any one of claims 1 to 8 is soldered to a feeding portion of a glass plate with a conductive portion by using the Sn-Ag-Cu-series, lead-free solder alloy according to any one of claims 1 to 8.
